# DEMANDE DE BREVET EUROPEEN

(11) **EP 0 807 962 A1**
(43) Date de publication de la demande: **19.11.1997**
(21) Numéro de dépôt: 97401060.5
(22) Date de dépôt: 13.05.1997
(51) Int. Cl.: H01L 21/28, H01L 21/331

(54) **Procédé d'obtention de contacts conducteurs auto-alignés pour composants électroniques**

(30) Priorité: 15.05.1996 FR 9606091
(71) Demandeur: FRANCE TELECOM, 75015 Paris (FR)
(72) Inventeur: Etrillard, Jackie, 78130 St Arnoult en Yvelines (FR)
(74) Mandataire: Dubois-Chabert, Guy

(57) **Abrégé**

Selon ce procédé, on forme, sur un substrat (2) destiné à porter le composant, une couche inférieure (10), et une structure dont une partie comporte une ouverture (18) sensiblement en forme de trapèze, on grave, avec transfert de pente, la couche inférieure à travers l'ouverture, on dépose une première couche conductrice puis une couche auxiliaire sur l'ensemble obtenu, la partie (80) de la première couche formée au fond de l'ouverture constituant un premier contact, on élimine ladite structure ainsi que la couche inférieure, on dépose sur l'ensemble obtenu une deuxième couche conductrice pour former au moins un deuxième contact (82, 84) et l'on élimine la partie de la couche auxiliaire formée sur le premier contact.

## Description

### DOMAINE TECHNIQUE

La présente invention concerne un procédé d'obtention de contacts conducteurs, ou électrodes, auto-alignés pour composants électroniques.

Par "composants électroniques", on entend aussi bien des composants électroniques unitaires, destinés à être utilisés individuellement, que des circuits intégrés.

L'invention permet de réaliser des électrodes auto-alignées sur des dispositifs semiconducteurs comme par exemple les transistors unipolaires, les transistors bipolaires et les diodes.

L'invention s'applique notamment à la fabrication de circuits logiques rapides, de circuits hyperfréquences et de circuits micro-opto-électroniques destinés aux systèmes de télécommunications.

Le procédé objet de l'invention permet
- de réduire le nombre d'étapes élémentaires utilisées classiquement pour réaliser des composants de ce type et
- d'éliminer les alignements de masques lithographiques, alignements qui sont difficiles à maîtriser.

Il en résulte une diminution des coûts de fabrication de ces composants et une plus grande facilité d'augmentation des performances des composants, sans réduction du rendement de fabrication de ces composants.

### ÉTAT DE LA TECHNIQUE ANTÉRIEURE

Il existe un très grand nombre de procédés permettant l'auto-alignement des contacts de composants électroniques.

Le but recherché est de simplifier les techniques permettant un auto-alignement en supprimant les étapes d'alignement, les plus contraignantes sur le plan de la précision, des différents niveaux lithographiques, ce qui est indispensable à un accroissement des performances des dispositifs et circuits.

On présente ci-après les diverses méthodes connues pour réaliser un auto-alignement.

La méthode la plus fréquemment utilisée, notamment en microélectronique sur silicium, met en oeuvre des espaceurs.

Ces derniers sont obtenus par des dépôts conformes de matériaux électriquement isolants (silice ou nitrure de silicium par exemple) généralement effectués par PECVD (pour "Plasma Enhanced Chemical Vapor Deposition) .

Schématiquement, la démarche consiste, après dépôt conforme d'un isolant réalisé sur un contact, ou électrode, métallique de section rectangulaire, à graver cet isolant d'une manière anisotrope.

La vitesse de gravure, qui est constante sur les différentes zones du motif obtenu, permet de laisser en place les parties de l'isolant déposées sur les flancs de l'électrode.

Ces parties constituent les espaceurs.

L'électrode métallique se trouve alors encapsulée dans un isolant.

L'auto-alignement est ensuite effectué : il suffit de déposer une couche métallique sur l'ensemble obtenu pour contacter les autres parties actives du composant.

Cette méthode qui met en oeuvre des espaceurs est également utilisée dans la technologie relative aux composés III-V.

On consultera à ce sujet l'article suivant :
A new self-alignment technology using bridged base electrode for small-scaled AlGaAs/GaAs HBT's, K. Nagata et al., IEEE trans. on elect. devices, vol.39, n°8, August 1992, p.1786

Dans ce cas, cependant, il n'est pas possible de coupler cette méthode avec la technique d'alliage sélectif qui est utilisée avec le silicium et qui permet l'auto-alignement des contacts drain et source sur la grille d'un transistor à effet de champ.

Une seconde méthode, appelée méthode "SAINT", est couramment utilisée dans l'Industrie pour les circuit intégrés III-V.

On consultera à ce sujet le document suivant :
K. YAMASAKI et al., Electronics letters, 4th February 1982, vol.18, n°3, p.119.

Cette seconde méthode utilise une technique de masquage par une structure à trois couches de résines dont la surgravure ("over-etching") maîtrisée et reproductible permet l'utilisation industrielle de cette seconde méthode.

On consultera à ce sujet les documents suivants :
K. MORIZUKA et al., IEEE Electron Device Letters, vol.9, n°11, Nov. 1988, p.598 à 600
AlGaAs/GaAs heterojunction bipolar transistors fabricated using a simple dual-lift-off Process, M.C.F. Chang et al., IEEE electron device letters vol. EDL8 n°7 July 1987, p.303.

Cependant, avec ce type de méthode utilisant la surgravure, le rendement de fabrication est assez mauvais.

Des méthodes d'auto-alignement utilisant l'écriture sur tranche par lithographie électronique sont à l'origine des meilleurs résultats obtenus à ce jour pour les dispositifs III-V.

Elle furent décrites pour la première fois dans le document suivant :
CHAO et al., IEDM Tech. Dig. Washington DC, Dec. 1983, p.613 à 616.

Elles utilisent une structure à deux ou trois couches de résines électrosensibles dont la plus sensible est la couche supérieure.

Ceci permet la formation d'une structure en T qui est ensuite métallisée et, après lift-off (dissolution des polymères), donne le contact métallique souhaité.

Les côtés du T permettent l'auto-alignement des contacts de drain et de source dans le cas de transistors unipolaires.

A ce sujet on consultera l'article suivant :
Developer selection for T-Shaped gate Fet's using PMMA/P[MMA-co-MMA]/PMMA, Ph. A. LAMARE, IEEE Trans. on elect. devices, vol.39, n°38, August 1992.

On connaît également une méthode d'auto-alignement par réalisation d'une structure de contact en forme de T qui utilise également la technique du lift-off mais à partir de lithographie optique classique.

A ce sujet, on consultera les documents suivants :
FR-A-2 711 451 et EP-A-0 650 185.

D'autres techniques utilisant cette méthode à partir d'une structure en "T" gravée ont également été étudiées.

Cependant, ce type de technique impose le choix de contacts métalliques susceptibles d'être gravés, d'une manière reproductible et facilement maîtrisable, de préférence par plasma et donc à partir de métaux non nobles.

On indique ci-après les inconvénients des quatre types de procédés connus, précédemment mentionnés, à savoir :
- les techniques utilisant des espaceurs,
- les techniques utilisant des surgravures,
- les techniques utilisant des différences de sensibilité de résines en lithographie électronique,
- les techniques utilisant des structures en T.

On considère d'abord les inconvénients des procédés fondés sur les espaceurs.

Les défauts majeurs liés à ces procédés sont :
- le coût de réalisation notamment sur les matériaux III-V qui sont sensibles aux défauts créés lors des dépôts par plasma mais aussi
- les difficultés de maîtrise dimensionnelle de ces structures sur de grandes dimensions.

En technologie III-V, il n'est pas possible d'utiliser les techniques d'alliage sélectif qui permettent un réel auto-alignement des contacts.

Il faut donc procéder à un alignement supplémentaire avec des tolérances qui restent très faibles et qui peuvent donc limiter les performances et réduire les rendements de fabrication.

Enfin, un espaceur constitue une capacité parasite entre un émetteur et une base, dans le cas d'une application aux transistors bipolaires par exemple, et entre un drain, une source et une grille dans le cas d'une application aux transistors à effet de champ.

On considère maintenant les inconvénients des procédés utilisant un auto-alignement par sur-gravure.

Les procédés utilisant des surgravures sont assez peut maîtrisables et sont fortement sujets à un manque d'uniformité sur de grandes dimensions.

En ce qui concerne les surgravures des matériaux III-V, il faut notamment tenir compte de l'orientation cristalline des substrats, ce qui rend difficile la technologie en ce qui concerne la conception des masques et qui rend aussi délicate l'amélioration des performances.

Cela réduit aussi considérablement les rendements de fabrication.

Dans le cas général de l'utilisation des surgravures, il faut également résoudre les problèmes posés par les effets de gravures locales constatées lors de gravures par plasma (lag effect, notch effect ...), particulièrement pour les petites dimensions.

On considère maintenant les inconvénients des procédés d'auto-alignement par lithographie électronique sur des résines de sensibilités différentes.

Ces procédés ont un coût élevé et sont assez peu applicables dans l'Industrie.

A ce sujet, on consultera le document suivant :
N. Samoto et al., Journ. Vacuum Sci. And Technol. B8(6), Nov. Dec. 1990, p.1335.

De plus, les sections de conducteurs restent assez faibles avec ce type de procédé, ce qui accroît les résistances d'accès aux zones actives.

En fait, il faut trouver un compromis entre la résolution et l'importance des sections du contact obtenu après lift off, ce qui limite les possibilités ultimes de ces procédés.

Enfin, avec ces procédés, on ne peut pas utiliser de méthode de dépôt métallique courante comme la pulvérisation cathodique qui est largement utilisée en microélectronique sur silicium.

On a recours aux techniques de dépôt par effet Joule ou par canon à électrons dans lesquelles les trajectoires atomiques sont plus anisotropes et réduisent l'épaisseur des dépôts latéraux qui sont observés lors de pulvérisations cathodiques.

On considère maintenant les inconvénients des procédés utilisant des structures en T et des techniques de lift-off.

Ces procédés imposent des équipements de dépôt permettant d'obtenir, pour les atomes à déposer, des trajectoires parfaitement symétriques par rapport à la normale au plan du substrat et ce en tout point de celui-ci.

Ces équipements sont d'un coût important et assez peu utilisés en technologie microélectronique.

Si toutefois les techniques classiques de dépôt, comme les techniques de dépôt par pulvérisation cathodique peuvent être utilisées, comme dans le cas des procédés décrits dans les documents FR-A-2 711 451 et EP-A-0 650 185, un dispositif de dépôt doit permettre d'obtenir une symétrie parfaite des différentes trajectoires atomiques lors de dépôts métalliques.

Là encore, l'adaptation de ce dispositif à des équipements de dépôt déjà présents sur le marché impose un investissement élevé.

### EXPOSÉ DE L'INVENTION

La présente invention a pour but de remédier aux inconvénients des procédés utilisant des structures de contact en forme de T.

Pour ce faire, la présente invention utilise non plus une structure de contact en T mais une structure de contact ayant une coupe transversale en forme de trapèze dont la plus petite des deux bases est la plus proche du substrat sur lequel on forme cette structure de contact.

La présente invention permet ;
- de donner à la section du contact déposé une valeur bien moins dépendante de sa largeur que dans le cas des structures en T obtenues par lithographie électronique et donc de mieux contrôler les résistances d'accès aux zones actives des composants que l'on veut former,
- de rendre les distances séparant les contacts auto-alignés (comme par exemple la distance entre l'émetteur et la base d'un transistor bipolaire dans le cas d'une application de l'invention à un tel transistor) indépendants des paramètres de lithographie et de gravure, et notamment de rendre ces distances indépendantes d'une sur-gravure dont on connaît les difficultés de maîtrise et de reproductibilité,
- de pouvoir donner à ces distances d'alignement des valeurs très faibles, susceptibles d'améliorer les performances des composants, indépendamment de la résolution ultime des techniques lithographiques utilisées, et
- d'utiliser des techniques classiques de dépôt de contacts conducteurs c'est-à-dire des techniques susceptibles d'être mise en oeuvre dans des équipements commercialement disponibles de l'industrie micro-électronique.

Il est à noter que la réalisation d'un auto-alignement conformément à la présente invention nécessite une uniformité des dépôts des contacts électriquement conducteurs.

De façon précise, la présente invention a pour objet un procédé d'obtention de contacts électriquement conducteurs auto-alignés d'un composant électronique, ce procédé étant caractérisé en ce qu'il comprend les étapes suivantes :
- on forme, sur un substrat destiné à porter le composant, une couche appelée couche inférieure,
- on forme sur cette couche inférieure une structure dont une partie comporte une ouverture et surplombe la couche inférieure, cette ouverture comprenant deux flancs placés en vis-à-vis et ayant une coupe transversale sensiblement en forme de trapèze, la plus petite des deux bases du trapèze étant la plus proche de la couche inférieure, les flancs de l'ouverture correspondant aux deux autres côtés du trapèze,
- on grave la couche inférieure à travers cette ouverture, pour y prolonger cette dernière jusqu'au substrat, par une technique de gravure avec transfert de pente,
- on dépose une première couche électriquement conductrice, perpendiculairement à la surface du substrat, sur l'ensemble résultant des étapes précédentes, une partie de cette première couche se formant au fond de l'ouverture et constituant un premier contact du composant, ce premier contact étant associé à une première couche active présente sur le substrat,
- on forme une couche auxiliaire sur l'ensemble résultant des étapes précédentes, de telle manière que l'épaisseur totale de la première couche et de la couche auxiliaire ne dépasse pas l'épaisseur de la couche inférieure, une partie de cette couche auxiliaire se formant sur ladite partie de la première couche et une autre partie de cette couche auxiliaire se formant sur les flancs de l'ouverture,
- on élimine ladite autre partie,
- on élimine ladite structure ainsi que la couche inférieure,
- en vue de former au moins un deuxième contact du composant, associé à une deuxième couche active présente sur le substrat, on dépose une deuxième couche conductrice sur l'ensemble résultant des étapes précédentes, perpendiculairement à la surface du substrat, ce substrat étant préalablement gravé pour permettre auxdits contacts d'êre formés sur les couches actives correspondantes, et
- on forme, à partir de cette deuxième couche, ce deuxième contact, ce dernier étant électriquement isolé du premier contact, et l'on élimine également ladite partie de la couche auxiliaire.

La couche inférieure peut être faite d'un matériau diélectrique, organique ou métallique.

Ladite structure peut être éliminée par la méthode du lift-off puis la couche inférieure peut être éliminée par gravure isotrope sélective par rapport au premier contact et au substrat.

Ladite structure peut être formée de la façon suivante :
- on forme sur la couche inférieure une couche supérieure faite d'une résine choisie dans le groupe comprenant les résines photosensibles et les résines électrosensibles, et
- on crée ladite ouverture dans la couche supérieure, par sensibilisation puis développement de la couche supérieure.

Selon un mode de mise en oeuvre particulier du procédé objet de la présente invention, avant de former la couche supérieure, on forme sur la couche inférieure une couche intermédiaire ayant une vitesse de gravure latérale plus grande que celle de la couche supérieure, et
- on grave cette couche intermédiaire par une technique de gravure avec transfert de pente, à travers l'ouverture de la couche supérieure, avant de prolonger cette ouverture dans la couche inférieure.

De préférence, pour faciliter l'élimination de la couche intermédiaire et de la couche supérieure, la couche intermédiaire est gravée par une technique de gravure isotrope pour y former deux cavités débouchant respectivement sur les flancs de l'ouverture.

La couche intermédiaire peut être une couche de résine.

La couche supérieure et la couche intermédiaire, dont l'ensemble constitue ladite structure peuvent être éliminée par la méthode appelée lift-off.

La couche auxiliaire peut être une multicouche comprenant une couche diélectrique ou métallique et une autre couche métallique déposée sur cette dernière.

Ladite partie de la couche auxiliaire peut être éliminée par la méthode appelée lift-off.

Ladite autre partie de la couche auxiliaire formée sur les flancs de l'ouverture peut être éliminée par usinage ionique.

La présente invention permet de former, sur un substrat, un contact métallique en forme de trapèze dont la plus grande des deux bases est la plus éloignée du substrat et surplombe donc la surface de ce dernier (ou la surface de couches préalablement déposées ou formées par épitaxie sur ce substrat).

L'épaisseur de ce contact peut varier de quelques dizaines à quelques centaines de nanomètres.

Le contact peut être formé par dépôt à partir d'équipements classiques de dépôt à condition toutefois que les trajectoires des atomes des matériaux que l'on dépose soient majoritairement perpendiculaires à la surface du substrat et que l'uniformité du dépôt soit correcte sur la totalité de la structure sur laquelle on fait ce dépôt.

Une pluralité de dépôts peuvent se succéder pour former le contact considéré.

La précision de l'auto-alignement permis par la présente invention peut être de quelques dizaines à quelques centaines de nanomètres.

La distance entre les contacts auto-alignés peut être calculée a priori en connaissant les vitesses de gravure des divers matériaux utilisés mais également en choisissant l'épaisseur du dépôt électriquement conducteur constituant le contact en forme de trapèze et l'épaisseur de la couche auxiliaire mentionnée plus haut.

Le procédé objet de l'invention permet donc une grande liberté quant au choix de la distance de séparation des contacts auto-alignés et donc quant aux résistances d'accès aux zones actives du composant dont on forme les contacts.

### BRÈVE DESCRIPTION DES DESSINS

La présente invention sera mieux comprise à la lecture de la description d'exemples de réalisation donnés ci-après, à titre purement indicatif et nullement limitatif, en faisant référence aux dessins annexés sur lesquels :
- les figures 1A à 1L illustrent schématiquement des étapes d'un mode de mise en oeuvre particulier du procédé objet de l'invention, permettant l'obtention de contacts auto-alignés d'un transistor bipolaire, et
- les figures 2A à 2D illustrent schématiquement des étapes d'un autre mode de mise en oeuvre particulier du procédé objet de l'invention, permettant l'obtention de contacts auto-alignés d'un transistor à effet de champ.

### EXPOSÉ DÉTAILLÉ DE MODES DE RÉALISATION PARTICULIERS

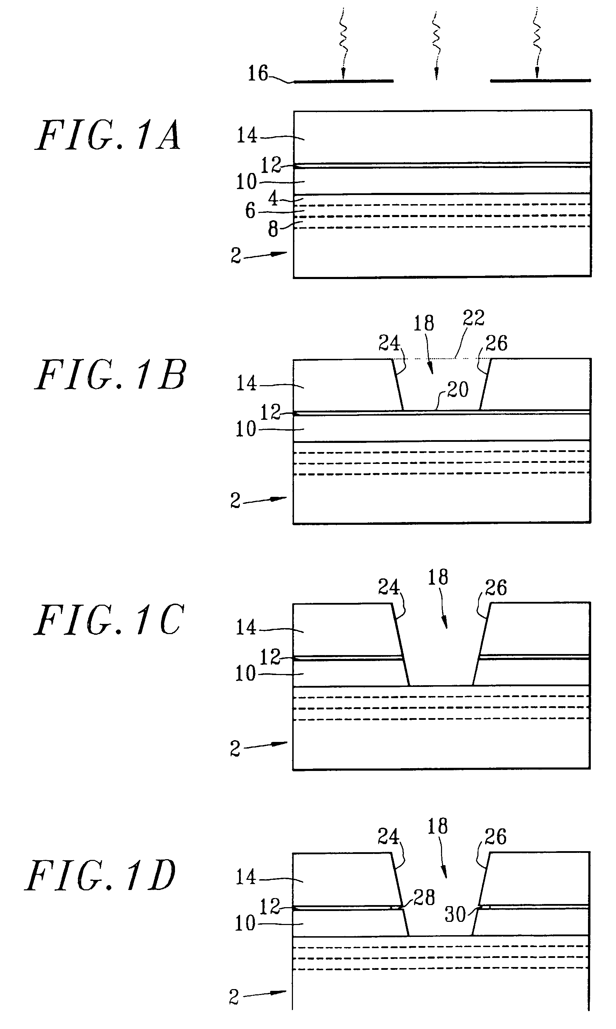

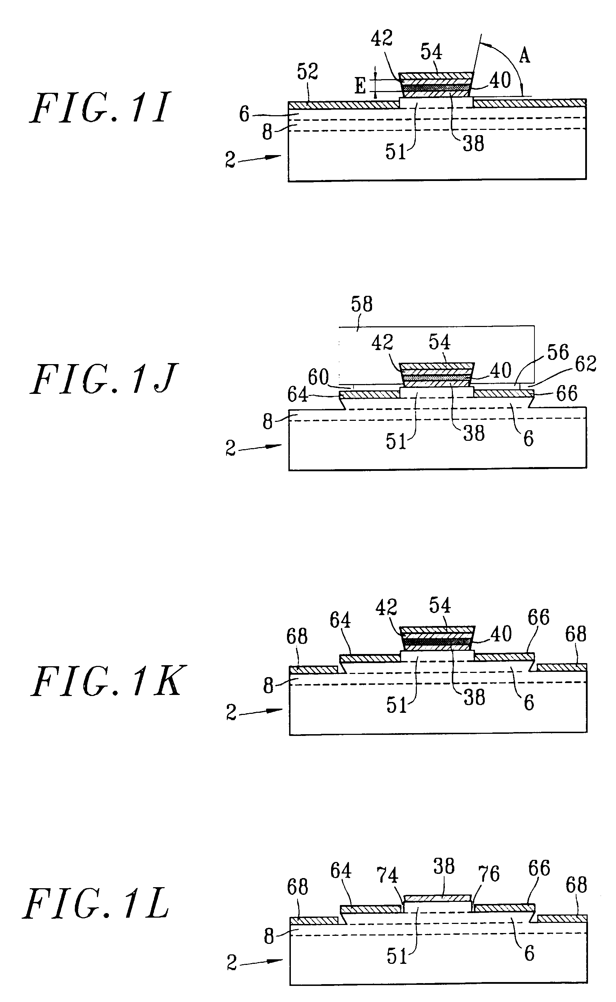

Les figures 1A à 1L illustrent schématiquement des étapes d'un procédé conforme à l'invention, permettant d'obtenir des contacts métalliques auto-alignés sur un substrat par exemple en InP.

Ces contacts sont ceux d'un composant électronique que l'on veut former (en plusieurs exemplaires) sur ce substrat.

Les figures 1A à 1L sont aussi des vues schématiques en coupe transversale de ce composant à différents stades de sa fabrication.

Dans l'exemple représenté, ce composant est un transistor bipolaire.

On voit sur la figure 1A le substrat 2 sur lequel sont présents les couches actives 4, 6 et 8 du composant, en l'occurrence une couche d'émetteur 4, une couche de base 6 et une couche de collecteur 8.

La couche d'émetteur 4 et la couche de collecteur 8 sont respectivement la couche la plus proche et la couche la plus éloignée de la surface supérieure du substrat tandis que la couche de base 6 est comprise entre la couche d'émetteur et la couche de collecteur.

Comme on le voit sur la figure 1A, conformément à la présente invention, on commence par déposer sur le substrat 2 (muni des couches actives 4, 6 et 8) une couche diélectrique 10 de Si₃N₄ de 600 nm d'épaisseur par la méthode PECVD.

Sur cette couche 10 on dépose ensuite par centrifugation une couche 12 de résine constituée par du polyméthylmétacrylate ou PMMA dont l'épaisseur vaut environ 400 nm.

On utilise par exemple une couche de PMMA du genre de celui qui est commercialisé par la société KTI.

Cette couche 12 est recuite à 175°C pendant 30 minutes afin d'en évacuer les solvants que ce PMMA contient initialement.

Sur cette couche 12 de PMMA on dépose ensuite par centrifugation une couche 14 d'une résine photosensible ("*photoresist*") dont l'épaisseur vaut environ 2 µm.

Dans l'exemple décrit, cette couche 14 est une couche de la résine commercialisée par la société Hoechst sous la référence AZ4210.

On photo-lithographie ensuite une zone de cette couche de résine 14 au moyen d'un rayonnement ultraviolet, à travers un masque 16 dont la forme est appropriée à l'émetteur du transistor que l'on veut former.

On développe ensuite cette couche 14 (figure 1B).

Puis cette couche 14 est soumise à un traitement ultraviolet de stabilisation pendant 30 minutes.

Ensuite cette couche 14 est recuite à 115°C pendant 15 minutes.

Puis elle est à nouveau recuite à 135°C pendant 15 minutes.

On voit sur la figure 1B l'ouverture 18 créée au niveau de la zone considérée après développement de la couche 14.

Cette ouverture 18 a, lorsqu'elle est vue en coupe transversale, la forme d'un trapèze.

La petite base 20 et la grande base 22 de ce trapèze sont parallèles à la surface supérieure du substrat (qui porte la couche 10).

Comme on le voit sur la figure 1B, la grande base 22 est plus éloignée du substrat que la petite base 20.

Les deux autres côtés du trapèze correspondent aux flancs 24 et 26 de l'ouverture 18.

Cette forme de trapèze résulte des traitements thermiques mentionnés ci-dessus.

Dans l'exemple donné, l'irradiation à travers le masque 16 a lieu perpendiculairement à la surface de la couche 14, de sorte que le trapèze est isocèle.

Au lieu d'utiliser une résine photosensible pour former la couche 14, on pourrait utiliser une résine électrosensible dans laquelle on formerait encore l'ouverture 18 et au lieu d'utiliser Si₃N₄ pour former la couche 10, on pourrait utiliser une résine photosensible fortement recuite ou une couche de tungstène.

Ensuite, la couche 12 et la couche 10 sont successivement gravées jusqu'à la surface supérieure du substrat 2 pour prolonger l'ouverture jusqu'à celui-ci, comme on le voit sur la figure 1C.

On utilise pour ce faire une technique de gravure par plasma permettant un transfert de pente.

Ainsi, vue en coupe transversale sur la figure 1C, la partie de l'ouverture 18 située dans la couche 10 a aussi la forme d'un trapèze isocèle.

Ensuite, comme on le voit sur la figure 1D, la couche 12 de PMMA est surgravée, par un procédé de gravure isotrope, pour y former deux cavités 28 et 30 débouchant respectivement sur les flancs 24 et 26 de l'ouverture 18.

Dans une variante non représentée, cette surgravure précède la gravure de la couche 10.

Ces deux cavités permettront, comme on le verra plus loin, un *"lift-off"* pour éliminer la couche 14.

Pour former les cavités 28 et 30, on utilise par exemple un réacteur de gravure par plasma micro-onde de type *"downstream",* par exemple du genre de ceux qui sont commercialisés par la société *Plasma Technology,* et un mélange d'oxygène et de N₂O.

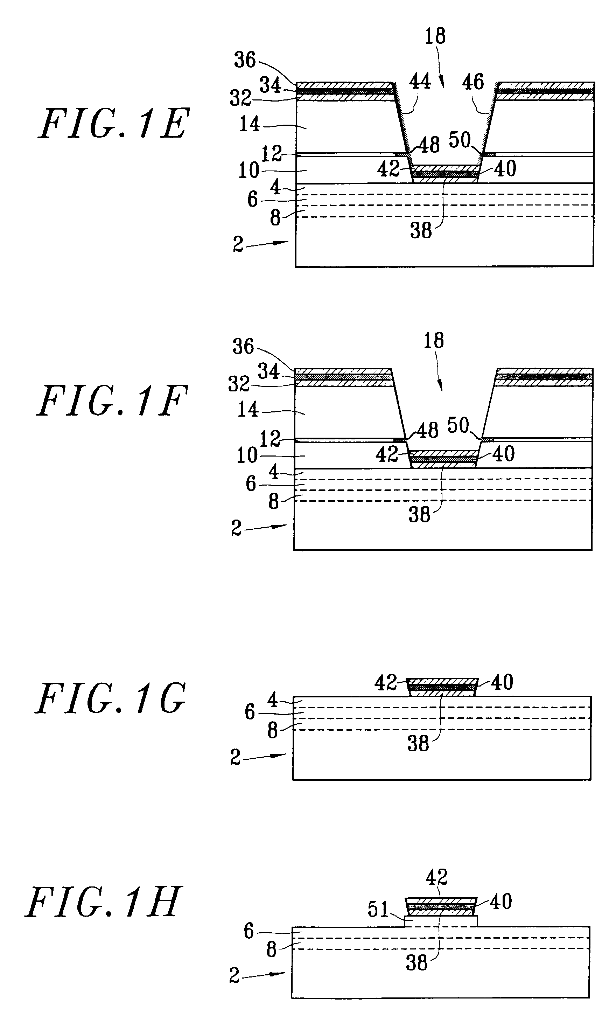

Ensuite, comme on le voit sur la figure 1E, on dépose successivement sur l'ensemble ainsi obtenu une couche métallique 32, une couche 34 de Si₃N₄ et une couche métallique 36.

Ces dépôts successifs se font perpendiculairement à la surface (supérieure) du substrat 2.

Dans ces conditions, des parties 38, 40, 42 appartenant respectivement à ces couches 32, 34 et 36, se déposent successivement au fond de l'ouverture 18.

La partie 38 de la couche 32 se dépose sur le substrat 2 ou, plus précisément, sur la couche d'émetteur 4 dont est muni ce substrat.

Compte tenu de la forme de trapèze isocèle de l'ouverture 18, cette partie 38, qui est destinée à former le contact d'émetteur du transistor bipolaire, a également la forme d'un trapèze isocèle, comme on le voit sur la figure 1E.

On précise que les épaisseurs des couches 38, 40 et 42 sont choisies de façon que l'épaisseur totale de ces couches ne dépasse pas l'épaisseur de la couche 10 de Si₃N₄.

La couche 32 est en fait une double couche de titane et d'or mais pourrait également être constituée par une unique couche métallique.

La couche 34 est une couche de 80 nm d'épaisseur de Si₃N₄ ou de tout autre matériau rapidement soluble dans l'acide fluorhydrique.

La partie 40 de cette couche 34 permet un "lift-off" sélectif dont il sera question par la suite.

La couche 36 est une couche de tungstène dont l'épaisseur vaut 100 nm.

Lors du dépôt des couches 32, 34 et 36, une partie des matériaux constitutifs de ces couches se dépose sur les flancs 24 et 26 de l'ouverture 18 et également dans les cavités 28 et 30.

Les dépôts correspondants ont respectivement les références 44, 46, 48 et 50 sur la figure 1E.

On élimine ensuite les dépôts latéraux 44 et 46 qui ont eu lieu sur les flancs de l'ouverture 18.

Pour ce faire, on utilise une gravure par usinage ionique sous incidence non nulle (c'est-à-dire de façon non perpendiculaire à la surface supérieure du substrat 2) .

Pour cet usinage ionique, on s'appuie sur la forme particulière de la courbe donnant le coefficient de pulvérisation cathodique des métaux en fonction de l'angle d'indice du faisceau ionique.

La vitesse de gravure par usinage ionique étant plus importante sur les dépôts inclinés par rapport à la surface du substrat que sur les dépôts parallèles à cette surface, on aboutit à la structure représentée en coupe transversale sur la figure 1F.

Il est à noter que les dépôts 48 et 50 qui ont eu lieu dans les cavités de la couche 12 ne sont pas éliminés par cet usinage ionique.

On effectue alors un premier "lift-off" par dissolution des résines constitutives des couches 12 et 14 dans un bain de trichloréthylène et par gravure isotrope de la couche 10, par dissolution de cette couche 10 dans une solution tamponnée d'acide fluorhydrique.

Il est à noter que les dépôts 48 et 50 (qui ne sont plus rattachés à la partie 42 mentionnée plus haut) disparaissent au cours de ces dissolutions.

On aboutit alors à la structure schématiquement représenté en coupe transversale sur la figure 1G.

Dans un mode de mise en oeuvre non représenté, on n'utilise aucune couche intermédiaire 12 et la couche de résine 14 est directement formée sur la couche 10 de Si₃N₄.

Dans ce cas, cette couche 10 est utilisée comme unique couche de "lift-off".

Ce mode de mise en oeuvre particulier non représenté est plus simple mais seulement utilisable avec des matériaux semi-conducteurs et des parties 38, 40 et 42 non significativement attaquées par l'acide utilisé pour la dissolution de la couche 10 de Si₃N₄, l'acide fluorhydrique dans l'exemple considéré.

On aboutit encore à la structure représentée en coupe transversale sur la figure 1G.

En utilisant les parties 38, 40 et 42 en tant que masque de gravure, on grave alors la couche d'émetteur 4 de façon anisotrope, par un plasma à bas niveau de défauts induits.

On obtient ainsi la structure représentée en coupe transversale sur la figure 1H où l'on voit l'émetteur 51 du transistor, qui résulte de cette gravure de la couche 4.

Ensuite, on dépose une couche métallique 52, perpendiculairement à la surface du substrat, sur la structure que l'on voit sur la figure 1H.

La structure qui en résulte est schématiquement représentée en coupe transversale sur la figure 1I.

On voit sur cette figure 1I qu'une partie 54 de cette couche 52 se dépose sur la partie 42 en tungstène.

Cette couche 52 est la couche de contact de base du transistor que l'on veut former.

Comme précédemment, cette couche 52 peut être une double couche de titane et d'or mais on pourrait également utiliser une unique couche métallique pour former la couche 52.

Il est à noter que la distance entre le contact d'émetteur 38 et les contacts de base (ultérieurement formés à partir de la couche 52) est égale au produit de l'épaisseur totale E des parties 40 et 42 par la cotangente de l'angle A que fait chaque côté latéral du contact d'émetteur 38 avec la surface supérieure du substrat 2.

On procède ensuite à une deuxième étape lithographique utilisant également une structure à deux couches de résines pour définir les contacts de base du transistor.

Plus précisément, on dépose sur la structure que l'on voit en coupe transversale sur la figure 1J une couche 56 de PMMA puis une couche 58 de résine photosensible (voir la figure 1J).

La couche 56 a par exemple une épaisseur de 400 nm et la couche 58 une épaisseur de 2 µm.

On insole ensuite la structure ainsi obtenue avec un masque approprié.

On développe la résine photosensible ainsi insolée.

On grave les extrémités de la couche 56 qui apparaissent à la suite de ce développement, par exemple au moyen d'un plasma de type "*down stream*".

On obtient ainsi, de part et d'autre de la structure, deux cavités 60 et 62 dans la couche 56, cavités qui permettront ultérieurement un "lift-off".

On grave ensuite la couche de contact de base 52 en utilisant comme masque la couche 58 que l'on a photolithographiée.

Cette gravure de la couche de contact de base 52 est effectuée par usinage ionique et permet d'obtenir deux contacts de base 64 et 66 de part et d'autre de l'émetteur 51 du transistor.

Dans une variante non représentée, on dépose les contacts de base en utilisant la méthode du "lift-off" à l'aide d'une résine inversible évitant l'utilisation de l'usinage ionique pour graver les contacts 64 et 66.

Ensuite, en revenant à la figure 1J, on utilise encore la couche photolithographiée 58 comme masque pour enlever, par gravure, les parties de la couche de base qui sont situées au-dessus des zones destinées à constituer le collecteur du transistor.

Cette gravure est suivie d'une gravure isotrope et d'un éventuel nettoyage chimique pour sous-graver *("over etch")* légèrement la couche de base, comme on le voit sur la figure 1J.

Ensuite, on dépose sur le substrat une couche de contact de collecteur 68 (voir la figure 1K), perpendiculairement à la surface du substrat.

Cette couche de contact de collecteur 68 est par exemple une double couche de titane et d'or mais pourrait être simplement une couche métallique.

Après un *"lift-off"* effectué au moyen de la couche 56 de PMMA, on obtient la structure vue en coupe transversale sur la figure 1K.

Dans une variante non représentée, on procède à la gravure des parties de la couche de base qui sont situées au dessus des zones destinées à constituer le collecteur du transistor, en utilisant les contacts d'émetteur et de base comme masque de gravure.

On dépose ensuite les contacts de collecteur par lift-off à l'aide d'une résine inversible.

En revenant à la figure 1K, on procède enfin à un dernier *"lift-off"* sélectif permettant d'éliminer les parties 40, 42 et 54 surmontant la partie 38 (contact d'émetteur) sans attaquer significativement aucune des couches ou contacts présents à la surface du substrat 2.

Ensuite, on élimine par une gravure anisotrope à faible quantité de défauts induits les zones intermédiaires 74 et 76 (figure 1L) situées entre l'émetteur 51 et les contacts de base 64 et 66.

On obtient ainsi la structure représentée schématiquement en coupe transversale sur la figure 1L.

Ensuite, on procède au recuit des contacts d'émetteur, de base et de collecteur pour terminer le transistor.

De façon classique, une étape ultérieure non représentée permet d'isoler le transistor de la figure 1L des autres transistors (non représentés) que l'on a fabriqué en même temps.

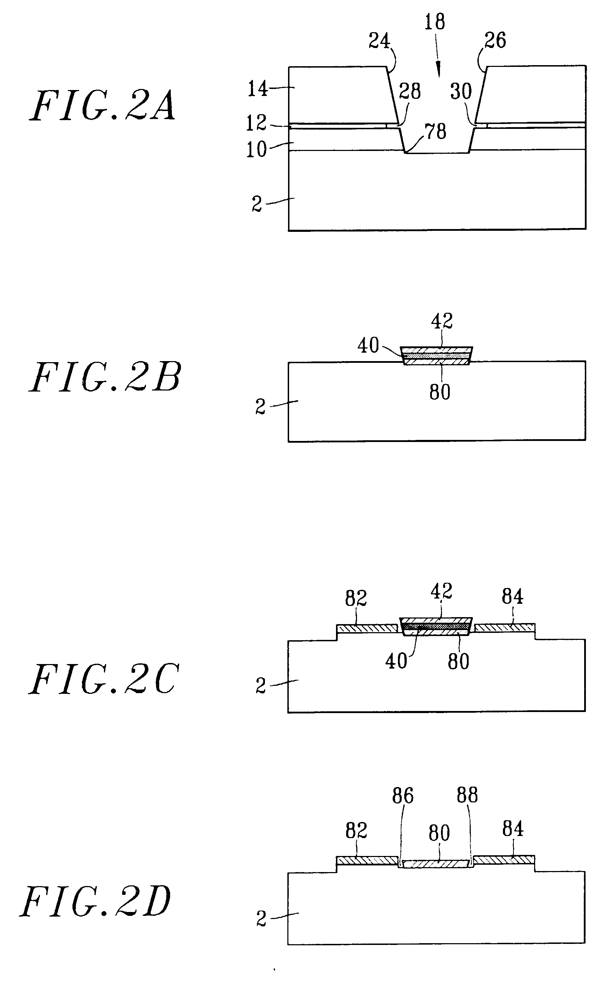

Les figures 2A à 2D illustrent schématiquement des étapes d'obtention de contacts conducteurs auto-alignés pour un transistor à effet de champ.

Les zones préalablement formées sur le substrat 2 et correspondant respectivement à la grille, à la source et au drain de ce transistor ne sont pas représentées.

On commence par traiter le substrat comme on l'a expliqué dans la description des figures 1A à 1D.

Ensuite, comme le montre schématiquement la figure 2A, on effectue, si cela est nécessaire, une gravure humide ou une gravure sèche de la structure obtenue pour prolonger l'ouverture 18, avec transfert de pente, dans le substrat 2.

On forme ainsi une cavité 78 *("recess")* dans ce substrat 2, cavité qui est destinée à recevoir le contact de grille du transistor à effet de champ.

Il est à noter que la formation de cette cavité 78 est seulement nécessaire pour certains transistors à effet de champ.

Pour d'autres transistors de ce type, cette formation de la cavité 78 n'est pas nécessaire et l'ouverture 18 s'étend seulement jusqu'à la surface supérieure du substrat.

Ensuite, pour former le contact de grille 80 (figure 2B), on procède comme on l'a expliqué dans la description des figures 1E et 1F à propos de la formation du contact d'émetteur 38.

Ainsi le contact 80 est encore surmonté des parties 40 et 42 mentionnées plus haut.

On effectue ensuite un *"lift-off"* par dissolution des couches de résine 12 et 14 utilisées pour l'obtention du contact de grille 80 puis on élimine la couche de nitrure 10 également utilisée pour cette formation (on procèderait à la dissolution de cette seule couche 10 dans le cas de l'utilisation d'une seule couche de résine, à savoir la couche 14).

On obtient ainsi la structure que l'on voit en coupe transversale sur la figure 2B.

On procède ensuite à un second dépôt métallique pour former les contacts de drain et de source 82 et 84 qui sont auto-alignés par rapport au contact de grille 80, comme on le voit sur la figure 2C.

Un second niveau de lithographie, avec un masque de forme appropriée, permet ensuite de délimiter ces contacts de drain et de source 82 et 84.

Ensuite, par une gravure appropriée, on isole le transistor à effet de champ obtenu des autres transistors (non représentés) que l'on a formé en même temps que lui sur le substrat.

Ceci est schématiquement illustré sur la figure 2C.

Ensuite, on procède à un second *"lift-off"* par dissolution de la partie 40 en Si₃N₄ et l'on élimine, par gravure anisotrope, les zones 86 et 88 situées entre le contact de drain 82 et le contact de grille 80 et entre le contact de source 84 et le contact de grille 80, comme l'illustre schématiquement la figure 2D.

## Revendications

1. Procédé d'obtention de contacts électriquement conducteurs auto-alignés d'un composant électronique, ce procédé étant caractérisé en ce qu'il comprend les étapes suivantes :
- on forme, sur un substrat (2) destiné à porter le composant, une couche (10) appelée couche inférieure,
- on forme sur cette couche inférieure une structure dont une partie comporte une ouverture (18) et surplombe la couche inférieure, cette ouverture comprenant deux flancs (24, 26) placés en vis-à-vis et ayant une coupe transversale sensiblement en forme de trapèze, la plus petite des deux bases du trapèze étant la plus proche de la couche inférieure, les flancs de l'ouverture correspondant aux deux autres côtés du trapèze,
- on grave la couche inférieure (10) a travers cette ouverture pour y prolonger cette dernière jusqu'au substrat, par une technique de gravure avec transfert de pente,
- on dépose une première couche électriquement conductrice (32), perpendiculairement à la surface du substrat, sur l'ensemble résultant des étapes précédentes, une partie (38, 80) de cette première couche se formant au fond de l'ouverture et constituant un premier contact du composant, ce premier contact étant associé à une première couche active présente sur le substrat,
- on forme une couche auxiliaire (34, 36) sur l'ensemble résultant des étapes précédentes, de telle manière que l'épaisseur totale de la première couche et de la couche auxiliaire ne dépasse pas l'épaisseur de la couche inférieure (10), une partie (40, 42) de cette couche auxiliaire se formant sur ladite partie (38, 80) de la première couche et une autre partie (44, 46) de cette couche auxiliaire se formant sur les flancs (24, 26) de l'ouverture (18),
- on élimine ladite autre partie (44, 46),
- on élimine ladite structure ainsi que la couche inférieure (10),
- en vue de former au moins un deuxième contact du composant, associé à une deuxième couche active présente sur le substrat, on dépose une deuxième couche électriquement conductrice (52) sur l'ensemble résultant des étapes précédentes, perpendiculairement à la surface du substrat, ce substrat étant préalablement gravé pour permettre auxdits contacts d'être formés sur les couches actives correspondantes, et
- on forme, à partir de cette deuxième couche, ce deuxième contact (64, 66; 82, 84), ce dernier étant électriquement isolé du premier contact, et l'on élimine également ladite partie (40, 42) de la couche auxiliaire.

2. Procédé selon la revendication 1, caractérisé en ce que la couche inférieure (10) est faite d'un matériau diélectrique, organique ou métallique.

3. Procédé selon la revendication 2, caractérisé en ce que ladite structure est éliminée par la méthode appelée *lift-off* puis la couche inférieure est éliminée par gravure isotrope sélective par rapport au premier contact et au substrat.

4. Procédé selon l'une quelconque des revendications 1 à 3, caractérisé en ce que ladite structure est formée de la façon suivante :
- on forme sur la couche inférieure (10) une couche supérieure (14) faite d'une résine choisie dans le groupe comprenant les résines photosensibles et les résines électrosensibles, et
- on crée ladite ouverture (18) dans la couche supérieure, par sensibilisation puis développement de la couche supérieure.

5. Procédé selon la revendication 4, caractérisé en ce que, avant de former la couche supérieure (14), on forme sur la couche inférieure (10) une couche intermédiaire (12) ayant une vitesse de gravure latérale plus grande que celle de la couche supérieure, et
- on grave cette couche intermédiaire (12) par une technique de gravure avec transfert de pente, à travers l'ouverture (18) de la couche supérieure, avant de prolonger cette ouverture dans la couche inférieure.

6. Procédé selon la revendication 5, caractérisé en ce que la couche intermédiaire (12) est gravée par une technique de gravure isotrope pour y former deux cavités (28, 30) débouchant respectivement sur les flancs (24, 26) de l'ouverture.

7. Procédé selon l'une quelconque des revendications 5 et 6, caractérisé en ce que la couche intermédiaire (12) est une couche de résine.

8. Procédé selon l'une quelconque des revendications 5 à 7, caractérisé en ce que la couche supérieure (14) et la couche intermédiaire (12), dont l'ensemble constitue ladite structure, sont éliminées par la méthode appelée lift-off.

9. Procédé selon l'une quelconque des revendications 1 à 8, caractérisé en ce que la couche auxiliaire est une multicouche comprenant une couche diélectrique ou métallique (34) et une autre couche métallique (36) déposée sur cette dernière.

10. Procédé selon la revendication 9, caractérisé en ce que ladite partie de la couche auxiliaire est éliminée par la méthode appelée lift-off.

11. Procédé selon l'une quelconque des revendications 1 à 10, caractérisé en ce que ladite autre partie (44, 46) de la couche auxiliaire (34, 36) formée sur les flancs (24, 26) de l'ouverture (18) est éliminée par usinage ionique.
